# FASCICULE DE BREVET EUROPEEN

(11) **EP 1 572 577 B1**
(45) Date de publication et mention de la délivrance du brevet: **18.04.2018**
(21) Numéro de dépôt: 03796155.4
(22) Date de dépôt: 04.12.2003
(51) Int. Cl.: B81C 1/00

(54) **PROCEDE DE TRAITEMENT D'UNE STRUCTURE POUR L'OBTENTION D'UN ESPACE INTERNE**
BEHANDLUNGSVERFAHREN EINER STRUKTUR, UM EINEN INNEREN RAUM HERZUSTELLEN
METHOD FOR TREATING A STRUCTURE TO OBTAIN AN INTERNAL SPACE

(30) Priorité: 20.12.2002 FR 0216401
(43) Date de publication de la demande: 14.09.2005
(73) Titulaire: Soitec, 38190 Bernin (FR)
(72) Inventeur: Bruel, Michel, 38113 Veurey-Voroize (FR)
(74) Mandataire: Regimbeau
(86) Numéro de dépôt international: PCT/FR2003/003584
(87) Numéro de publication internationale: WO 2004/065291

(56) Documents cités:
- EP-A2- 1 180 494
- WO-A-99/58985
- WO-A-02/076881
- DE-A- 10 110 234
- FR-A- 2 747 506
- GB-A- 2 211 991
- KLUTH P ET AL: "FABRICATION OF EPITAXIAL COSI2 NANOWIRES" APPLIED PHYSICS LETTERS, AMERICAN INSTITUTE OF PHYSICS. NEW YORK, US, vol. 79, no. 6, 6 août 2001 (2001-08-06), pages 824-826, XP001083193 ISSN: 0003-6951

## Description

La présente invention concerne le domaine des structures, en particulier multi-couches, présentant un espace interne d'épaisseur nanométrique ou micrométrique et s'étendant en général sur une surface plus grande que son épaisseur.

Dans le domaine des microsystèmes, par exemple pour réaliser des capteurs de pression, il est particulièrement avantageux de réaliser une structure capacitive multi-couche comprenant une plaquette massive de silicium et une membrane constituée par un film de silicium, la plaquette et cette membrane étant séparées par une couche d'un isolant tel que de l'oxyde de silicium, structure dans laquelle est réalisé un espace interne entre la plaquette de silicium et la membrane, de telle sorte qu'une variation de pression extérieure se traduit par une variation de la déformation de la membrane dans la zone de l'espace interne, perpendiculairement à cet espace, engendrant ainsi une variation de la capacité entre la membrane et la plaquette, dont la mesure permet de déterminer la variation de pression extérieure.

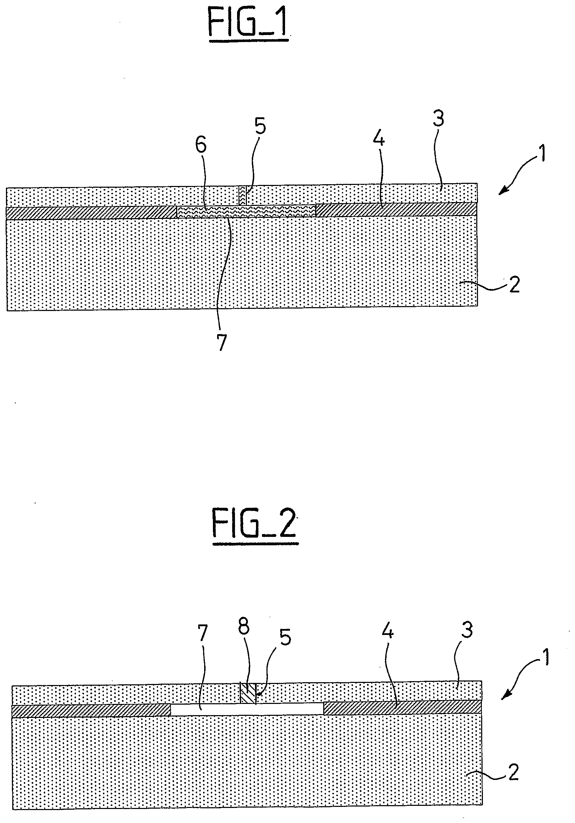

En référence aux figures 1 et 2 annexées, on va décrire ci-après la manière actuellement utilisée pour réaliser un tel espace interne.

En se reportant à la figure 1, on peut voir qu'il est connu de réaliser une structure 1 comprenant une plaquette ou couche de silicium 2, par exemple d'épaisseur sensiblement égale à cinq cent cinquante microns, et une plaquette ou couche de silicium 3, par exemple d'épaisseur sensiblement égale à deux microns, séparées par une couche 4 d'un isolant tel que de l'oxyde de silicium, par exemple d'épaisseur sensiblement égale à un micron.

On réalise un trou 5, généralement d'un diamètre sensiblement égale à cinq cents nanomètres, dans la plaquette 3 la moins épaisse et on procède à une attaque chimique de l'isolant 4 au travers de ce trou par un liquide chimique d'attaque 6 de façon à enlever cet isolant dans une zone environnant le trou et obtenir un espace interne 7. Puis, comme le montre la figure 2, on rebouche le trou 5 en formant un bouchon 8, l'espace interne 7 ainsi créé pouvant être rempli d'une ou plusieurs phases gazeuses ou mis sous vide avant d'être rebouché.

L'inventeur considère qu'une telle manière de procéder présente de nombreux inconvénients et difficultés.

La profondeur de pénétration du liquide chimique d'attaque entre les deux plaquettes pour attaquer la couche d'isolant et l'évacuation des produits de réaction dépendent de la section de passage du trou réalisé et de la distance entre les plaquettes qui détermine l'épaisseur de l'espace interne. La périphérie de l'espace interne créé présente un contour dont la dimension et la géométrie sont difficiles à contrôler.

Pour pouvoir reboucher le trou 5 sans que le matériau 8 de remplissage ne pénètre dans l'espace interne 7, ce trou 5 doit présenter un faible diamètre. De plus, pour que ce trou soit techniquement réalisable, l'épaisseur de la plaquette 3 doit être faible. Dans ces conditions, la plaquette 3 est déformable et il est difficile d'obtenir un espace interne d'épaisseur uniforme.

Il est en conséquence difficile, voire impossible, d'établir un compromis technique permettant d'obtenir un espace interne d'épaisseur nanométrique ou micrométrique, c'est-à-dire d'épaisseur pouvant être comprise entre une fraction de nanomètre et quelques microns, un espace interne de relativement grande surface et dont la périphérie présenterait un contour déterminé, d'utiliser des plaquettes dont l'une serait de faible épaisseur et d'éviter de déformer une telle plaquette sous l'effet des tensions superficielles exercées par le liquide chimique d'attaque.

Une méthode de création d'un espace interne entre deux électrodes par enlèvement de la matière d'une couche intermédiaire est également décrite dans le document WO-A-99/13562.

Une méthode de création d'un espace interne entre un substrat et une membrane par attaque chimique est décrite dans EP 1 180 494 A2.

L'inventeur a pu observer que des structures multi-couches à espaces internes d'épaisseur nanométrique ou micrométrique peuvent présenter un grand intérêt dans de nombreux autres domaines d'application.

En particulier, il serait en effet avantageux de pouvoir réaliser des espacements nanométriques d'épaisseur sensiblement uniforme, sous vide, entre les deux électrodes d'un système faisant appel à une émission électronique de champ dans un tel espacement, en particulier par effet tunnel, afin d'obtenir les champs électriques intenses nécessaires pour produire ces phénomènes d'émission, tout en utilisant des tensions électriques relativement faibles. Il s'avèrerait aussi particulièrement intéressant de pouvoir réaliser des espaces internes de grande surface dans des structures multicouches afin d'obtenir des diodes de grande capacité en terme de courant. De telles structures trouveraient des applications en particulier dans le domaine des systèmes thermiques utilisant l'effet Peltier, en particulier dans des systèmes de réfrigération tels que décrits dans la revue «APPLIED PHYSICS LETTERS », volume 78, pages 2572-2574 du 23 avril 2001.

La présente invention a pour but de réaliser des structures en particulier multi-couches présentant des espaces internes d'épaisseur nanométriques ou micrométriques, sans être contraint par les difficultés et les inconvénients précités.

La présente invention a tout d'abord pour objet un procédé de traitement d'une structure pour former un espace interne selon une des revendications 1 ou 4. La présente invention sera mieux comprise à l'étude de structures à espace interne et de modes de fabrication de ces structures, décrites à titre d'exemples non limitatifs et illustrés par le dessin sur lequel :
- la figure 1 représente une coupe transversale de la structure connue décrite plus haut, dans une étape de fabrication ;
- la figure 2 représente une coupe transversale de la structure connue de la figure 1, après fabrication ;
- la figure 3 représente une coupe transversale d'une première structure selon l'invention à une première étape de fabrication ;
- la figure 4 représente une vue de dessus de la structure de la figure 3 ;
- la figure 4a représente une vue de dessus d'une variante de la structure selon l'invention ;
- la figure 4b représente une vue de dessus une autre variante de la structure selon l'invention ;
- la figure 5 représente une coupe transversale de ladite première structure selon l'invention à une deuxième étape de fabrication ;
- la figure 6 représente une coupe transversale de ladite première structure selon l'invention à une troisième étape de fabrication ;
- la figure 7 représente une coupe transversale de ladite première structure selon l'invention à une étape ultime de fabrication ;
- la figure 8 représente une coupe transversale d'une deuxième structure selon l'invention à une première étape de fabrication ;
- la figure 9 représente une coupe transversale de ladite deuxième structure selon l'invention à une deuxième étape de fabrication ;
- la figure 10 représente une coupe transversale de ladite deuxième structure selon l'invention à une deuxième étape de fabrication ;
- la figure 11 représente une coupe transversale de ladite deuxième structure selon l'invention à une étape ultime de fabrication
- la figure 12 représente une troisième structure selon l'invention, à une étape de fabrication ;
- la figure 13 représente une coupe transversale de ladite troisième structure selon l'invention à une étape suivante de fabrication ;
- et la figure 14 représente une coupe transversale de ladite troisième structure selon l'invention à une étape finale de fabrication.

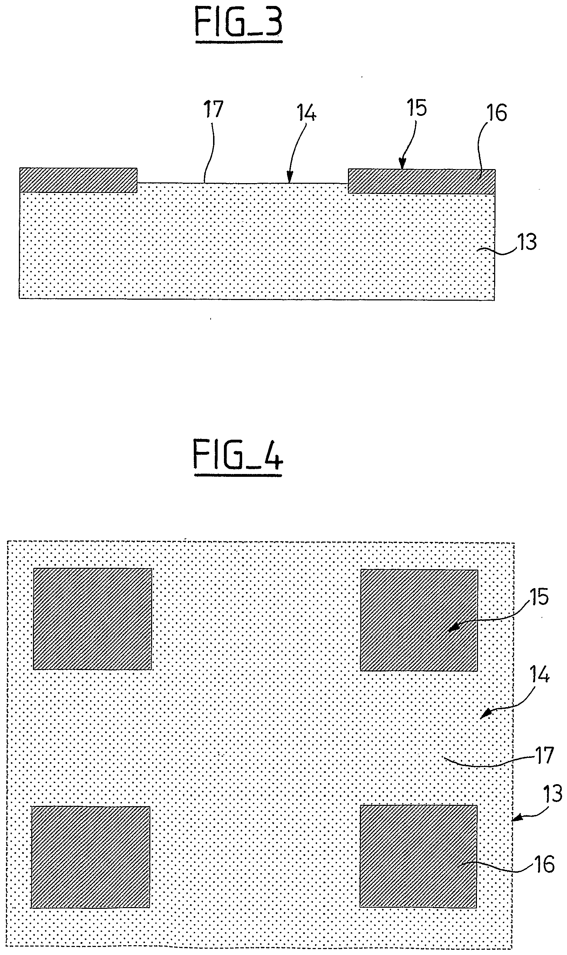

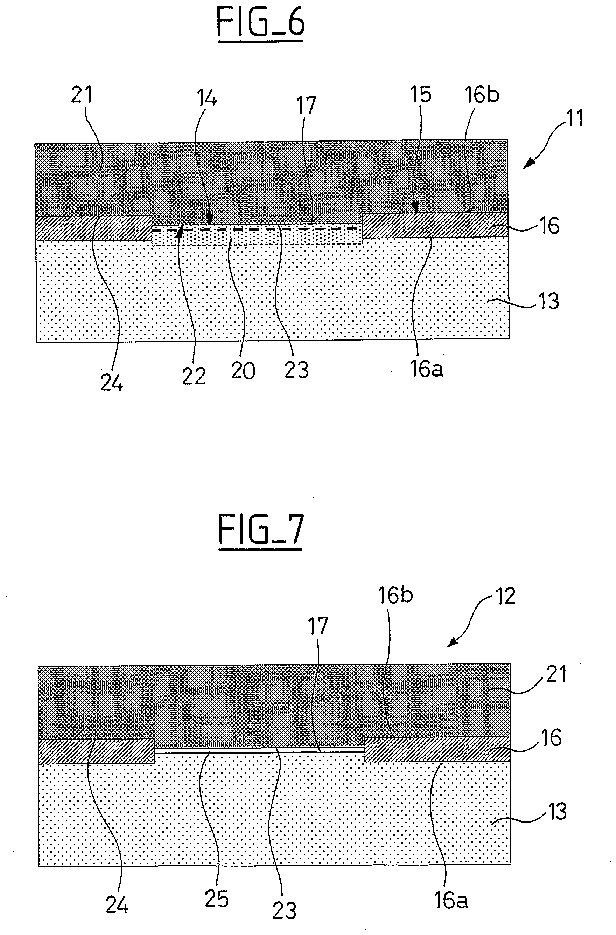

En se reportant aux figures 3 à 6, on va décrire les étapes permettant d'obtenir une structure initiale 11 permettant d'obtenir, après un traitement, une structure finale 12 représentée sur la figure 7.

On voit sur la figure 3 que l'on dispose d'une plaquette de silicium monocristallin 13 sur une surface frontale 14 de laquelle on a réalisé, par les techniques connues en microélectronique, une couche localisée 15 d'oxyde de façon à constituer une multiplicité de plots d'oxyde 16 distants et répartis sur la surface frontale 14, cette couche d'oxyde 15 pouvant être réalisée par oxydation du silicium dans un four sous atmosphère oxydante ou par dépôt par tout procédé connu notamment du type CVD ou PECVD. Ainsi, la face frontale 14 de la plaquette 13 présente une zone 17 exempte d'oxydation dans laquelle sont implantés les plots oxydés 16.

A titre d'exemple, la profondeur de la couche oxydée 15 constituant les plots 16 par rapport à la surface 14 de la plaquette 13 peut être d'environ deux cents nanomètres.

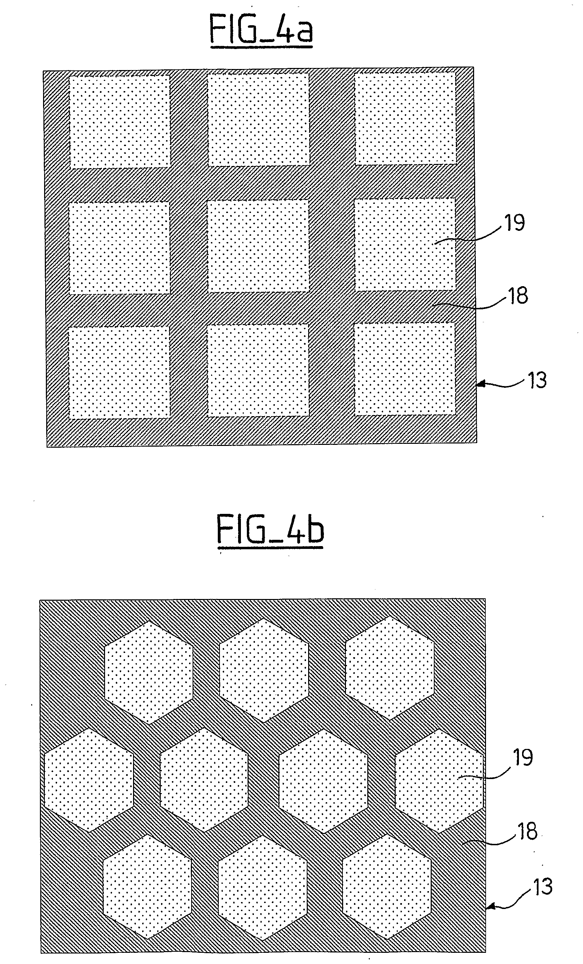

Dans la variante de réalisation représentée sur les figures 3 et 4, les faces frontales plots 16 peuvent représenter des surfaces carrées, par exemple de trois microns de côté, réparties selon un pas de dix microns.

Dans des variantes représentées sur les figures 4a et 4b, les plots oxydés 16 sont remplacés par des murs oxydés continus 18 constituant une grille déterminant des zones non oxydées 19, distantes et réparties. Sur la figure 4a, les zones 19 présentent un pourtour carré et sur la figure 4b, les zones 19 présentent un pourtour hexagonal.

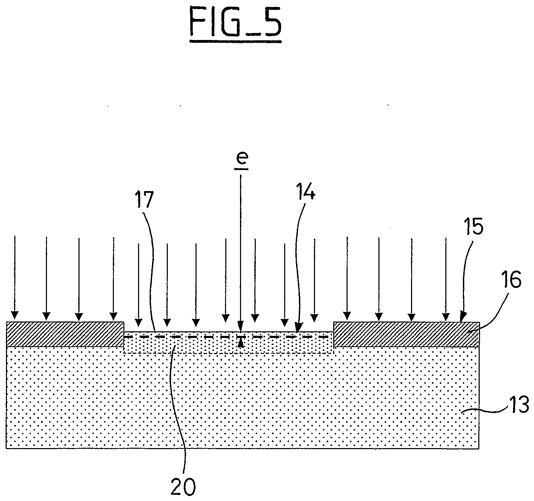

En se reportant à la figure 5, on peut voir qu'ensuite on procède, par tout moyen bien connu, à une implantation ionique d'amorphisation de la face frontale 14 de la plaquette 13 de façon à créer une région ou une couche superficielle amorphisée 20 dans la zone 17 non recouverte par les plots 16, respectivement dans les zones 19 non recouvertes par les murs 18.

Dans une variante, au moins la zone 17, respectivement les zones 19, de la plaquette 13 pourraient être recouverte d'une couche d'un autre matériau, par exemple de nanotubes de carbone, au travers de laquelle on produirait l'implantation ionique précitée.

Il est connu que l'amorphisation du silicium produit en général un gonflement du matériau et donc une élévation de la surface ainsi traitée, ce gonflement pouvant atteindre quelques pour cent de l'épaisseur amorphisée.

Dans l'article paru dans la revue « Physics Research » B 148 de 1999 pages 573-577, les auteurs montrent que le gonflement du SiC amorphisé peut conduire à une élévation de la surface traitée pouvant atteindre 10% de l'épaisseur de la couche amorphisée.

A titre indicatif, on peut choisir d'implanter des ions silicium dans la zone 17, respectivement les zones 19, de la plaquette 13, à l'énergie de 120KeV, à une température voisine de 0°C et à une dose de l'ordre de 2E15à 6E15 par centimètre carré. Dans ces conditions, on peut obtenir une couche superficielle amorphisée 20 sur la zone 17 non couverte d'oxyde, respectivement les zones 19, dont l'épaisseur e est d'environ 200 nanomètres.

Ainsi, dans l'exemple ci-dessus, l'élévation de la surface de la zone 6 amorphisée respectivement des zones 8, peut être comprise entre environ cinq nanomètres et vingt nanomètres en fonction de la dose implantée.

En se reportant à la figure 6, on peut voir qu'ensuite on peut procéder au dépôt, sur la face frontale 14 de la plaquette 13, d'une couche épaisse rigide 21, cette couche présentant une face arrière 22 épousant la forme de la face frontale 14 de cette plaquette. Ainsi, les plots 16, respectivement les murs 19, présentent des faces opposées 16a et 16b parallèles à l'interface 17-22 et en appui sur la plaquette 13 et la couche épaisse 21.

De préférence, on choisit des conditions de création de cette couche 21 de telle que d'une part la zone 23 de sa face 22 soit peu adhérente sur la zone non oxydée 17 de la plaquette 13, respectivement sur les zones 19, et que ses zones 24 soient adhérentes sur au moins une partie des surfaces frontales des plots oxydés 16, respectivement des murs 18.

Dans un exemple, la couche 21 peut être constituée par une première couche de tungstène d'environ 100 nanomètres d'épaisseur déposée par pulvérisation cathodique, puis d'une seconde couche obtenue par un dépôt épais électrolytique de cuivre d'environ cent microns.

Il est possible en outre d'effectuer un traitement thermique de densification de la couche 21 de façon à la rendre plus compacte et plus rigide. Un tel traitement peut être réalisé à une température de 350°C pendant trente minutes.

Après quoi, on obtient la structure initiale multi-couches 11.

Dans l'exemple ci-dessus choisi, on procède alors à un traitement thermique de la structure initiale 1 dans une gamme de température comprise entre par exemple 550°C et 850°C, préférentiellement entre 600°C et 650°C. en plaçant la structure initiale 11 par exemple dans un four ainsi réglé pendant quelques minutes ou dizaines de minutes.

Grâce à ce traitement thermique, il se produit une recristallisation par re-épitaxie de la région ou couche superficielle 20 antérieurement amorphisée. La couche initialement amorphisée se transforme alors en une couche cristalline de plus forte densité, cette cristallisation produisant une réduction de l'épaisseur de la région ou couche 20.

La plaquette 13 et la couche rapportée 21 étant maintenues l'une par rapport à l'autre, perpendiculairement à leur interface 14-22, dans la zone des plots 16, respectivement des murs 18, la réduction de l'épaisseur de la région ou couche superficielle 20 engendre un déplacement de la zone 17 de la face frontale 14 de la plaquette 13, respectivement des zones 19, dans le sens qui l'éloigne de la zone 23 correspondante de la couche épaisse 21 sur laquelle elle était préalablement en contact. Ce déplacement constitue un retrait de la zone 17 de la plaquette 13 perpendiculairement à l'interface entre cette zone 17 et la zone 23 de la couche épaisse 21.

Le déplacement ou retrait ci-dessus engendre la formation d'un espace interface interne 25 qui s'étend sur la zone 17 de la plaquette et autour des plots 16, respectivement sur les zones 18 et entre les murs 19, dont l'épaisseur s'étend parallèlement à l'interface et correspond sensiblement à l'amplitude du retrait.

Dans les conditions mentionnées plus haut, l'épaisseur de l'espace interne 25 obtenu peut être de l'ordre de cinq à vingt nanomètres.

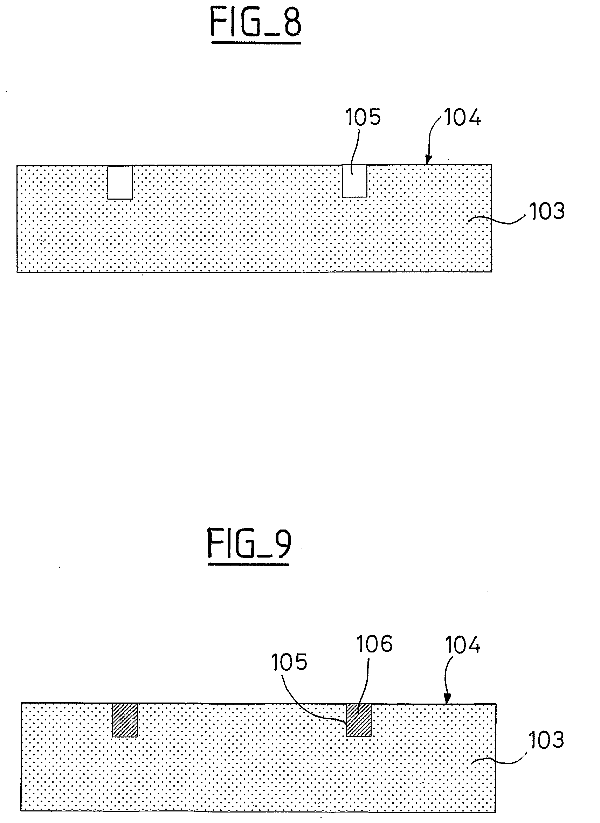

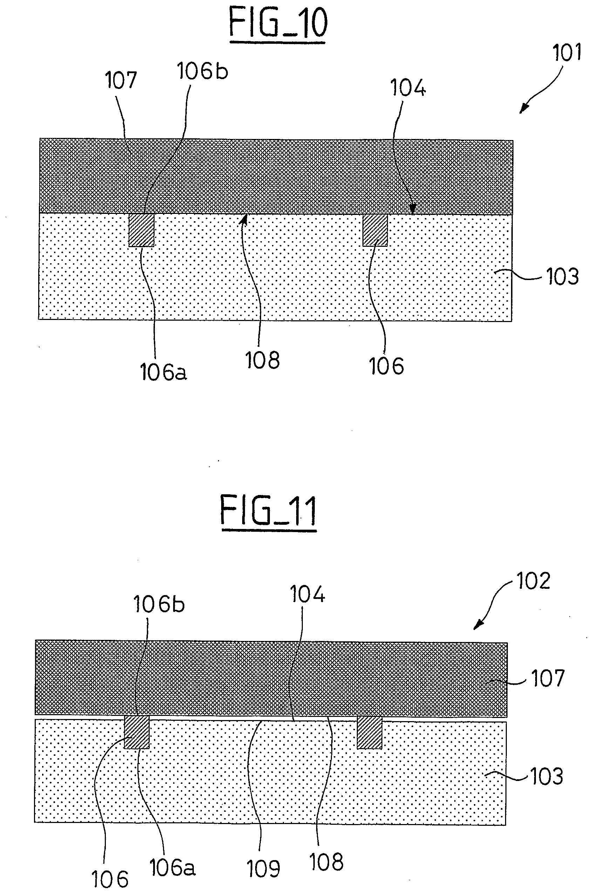

En se reportant aux figures 8 à 10, on va maintenant décrire les étapes permettant d'obtenir une structure initiale 101 permettant d'obtenir, après un traitement, une structure finale 102 représentée sur la figure 11.

On voit sur la figure 8 que l'on dispose d'une plaquette de silicium mono cristallin 103 dans une surface frontale 104 de laquelle on a réalisé, par exemple par les techniques connues de gravure utilisées en microélectronique, des creux ou caissons 105. Ces creux peuvent être des puits régulièrement répartis, de trois microns de côté répartis selon un pas de dix microns, ou des saignées continues, de trois microns de largeur, se croisant éventuellement pour constituer une grille au pas de dix microns. Dans un exemple de réalisation, ces creux 105 peuvent présenter une profondeur comprise entre cinq cent et deux mille nanomètres.

Comme le montre la figure 9, on procède au remplissage des creux 105 d'une matière susceptible de gonfler lors d'un traitement ultérieur.

Par exemple, on recouvre la surface 104 d'une couche d'oxyde tels qu'un phosphosilicate glass (PSG) fortement dopé en phosphore, par exemple à environ douze pour cent, par exemple par une méthode de type PECVD, un tel dépôt remplissant les creux 105. On applique ensuite un traitement de polissage mécano-chimique de façon à enlever la couche d'oxyde sur la surface 104 de la plaquette 103 à l'extérieur des creux 105 et à planariser cette surface et la surface extérieure de la matière remplissant les creux 105.

On obtient ainsi, dans les creux 105, des plots ou des murs 106 correspondant superficiellement aux plots 16 ou aux murs 18 de l'exemple précédent et présentant une face arrière 106a accolée au fond des creux 105.

Puis, comme le montre la figure 10, on recouvre la surface 104 et les plots ou murs 106 d'une couche épaisse rigide 107, cette couche 107 présentant une face arrière 108 accolée à la surface 104 de la plaquette 103 et à la face avant 106b des plots 106. Cette couche 107 peut être constituée comme la couche épaisse 21 de l'exemple précédent.

Ainsi, les plots ou murs 106 présentant des faces opposées 106a et 106b en appui respectivement sur la plaquette 103 et sur la couche épaisse 107, qui s'étendent sensiblement parallèlement à l'interface constituée par leurs faces accolées 104 et 108.

De préférence, cette couche épaisse 107 est peu adhérente sur la surface 104 de la plaquette 103 et plus fortement adhérente sur la surface extérieure des plots ou murs 106.

On obtient alors la structure initiale multi-couches 101.

Ensuite, compte tenu des matériaux indiqués en exemple précédemment, on place cette structure initiale 101 dans un four réglé à une température d'environ 850 à 950°C de façon à lui appliquer un traitement thermique.

Optionnellement, pour éviter les déformations dues à la pression atmosphérique, les traitements thermiques peuvent être réalisés sous vide ou sous faible pression.

L'application d'un tel traitement agit sur la matière constituant les plots ou murs 106 et génère, dans l'exemple décrit, la formation de micro-bulles gazeuses dans cette matière, ce qui provoque un gonflement de ces plots ou murs 106.

Ce gonflement engendre principalement un accroissement de l'épaisseur des plots ou murs 106, perpendiculairement à l'interface 104-108 de la plaquette 103 et de la couche épaisse 107.

Cet accroissement de l'épaisseur des plots ou murs 106, en appui respectivement sur la plaquette 103 et sur la couche épaisse 107 par leurs faces opposées 106a et 106b, provoque l'apparition de forces qui sont sensiblement perpendiculaires à l'interface 104-108 et qui produisent un déplacement de la plaquette 103 et de la couche épaisse 107 l'une par rapport à l'autre, perpendiculairement à l'interface 104-108, après décollement de leurs faces 104 et 107dans leurs zones s'étendant entre les plots ou murs 106.

Ce déplacement se traduit par la création d'un espace interne 109 entre la face frontale 104 de la plaquette 103 et la face arrière 108 de la couche épaisse 107 qui se sont écartées, sur la zone ou les zones s'étendant entre les plots ou murs 106 et dont l'épaisseur est sensiblement parallèle à cet interface.

On obtient alors la structure finale 102 représentée sur la figure 11.

Considérant l'exemple de réalisation mentionné plus haut, l'épaisseur de l'espace interne 109 pourrait être comprise entre dix et quarante nanomètres.

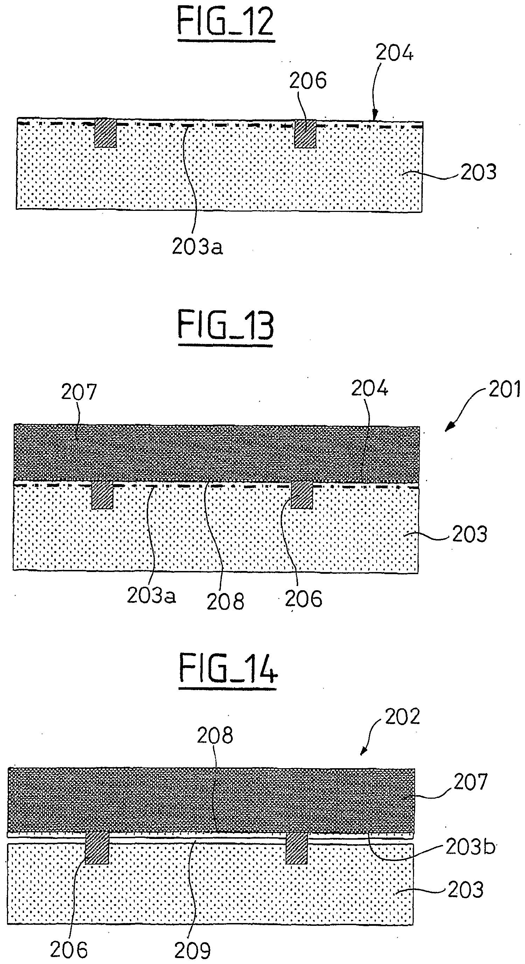

En se reportant aux figures 12 et 13, on va maintenant décrire les étapes permettant d'obtenir une structure initiale 201 permettant d'obtenir, après un traitement, une structure finale 202 représentée sur la figure 14.

On voit sur la figure 12 que l'on dispose, comme à l'étape de l'exemple précédent décrite en référence à la figure 9, d'une plaquette 203 de silicium mono-cristallin qui présente une surface frontale 204 dans laquelle sont réalisés des plots ou murs 206 une matière susceptible de gonfler lors d'un traitement ultérieur.

Dans cette variante, on procède alors à une fragilisation d'une zone 203a située en profondeur dans la plaquette 203 et s'étendant sensiblement parallèlement à la surface 204, entre les plots ou murs 206. A titre d'exemple, cette zone de fragilisation peut être obtenue par une implantation d'ions d'hydrogène par toute technique connue, suivie éventuellement d'un traitement thermique et peut être située à une distance de la surface 204 comprise entre quelques centaines de nanomètres et quelques microns.

On voit sur la figure 13 qu'ensuite on procède, comme à l'étape de l'exemple précédent décrite en référence à la figure 10, au dépôt d'une couche épaisse rigide 207 de recouvrement de la surface 104 et des plots ou murs 106. De préférence, l'adhérence de la couche 207 sur la plaquette 203, à leur interface 208, est supérieure à la résistance de la zone fragilisée 203a.

On obtient alors la structure initiale 201.

Ensuite, comme à l'étape de l'exemple précédent décrite en référence à la figure 11, on procède à un traitement des plots ou murs 206 afin de les faire gonfler.

Ce gonflement engendre l'apparition de forces qui sont sensiblement perpendiculaires à l'interface 208 et qui produisent une rupture de la plaquette 203 dans la zone fragilisée 203a. Cette rupture produit l'apparition d'un espace interne 209 dans cette zone 203a entre la couche superficielle 203b de la plaquette 203 qui reste accollée à la couche épaisse 207 dans l'interface 208 et le reste de cette plaquette 203, qui se sont déplacés l'un par rapport à l'autre perpendiculairement à l'interface 208.

Compte tenu de la disposition de la zone fragilisée mentionnée plus haut en exemple, cet espace interne 209 s'étend sensiblement parallèlement à l'interface 204 et, dans les mêmes conditions, son épaisseur correspond sensiblement à celle obtenue dans l'exemple précédent décrit en référence à la figure 11.

On obtient alors la structure finale 202 représentée sur la figure 14.

Les structures finales 12, 102 et 202 qui viennent d'être décrites peuvent être appliquées, sans que les exemples ci-après soient limitatifs, dans le domaine des micro-structures (MEMS) pour réaliser des capteurs de pression, des microphones, des générateurs vibrants, dans le domaine des structures à émission des champs pour réaliser des diodes, des générateurs thermodynamiques, des dispositifs réfrigérants.

La présente invention ne se limite pas aux exemples ci-dessus décrits. En particulier, les méthodes proposées de création d'un espace interne pourraient être combinées. L'espace interne créé pourrait s'étendre sur une zone limitée et prédéterminée de l'interface, dans cette dernière ou à distance. Les structures proposées pourraient être constituées par des plaquettes ou des couches ou des plots ou murs en d'autres matériaux que ceux donnés en exemple et pourraient comprendre d'autres couches en d'autres matériaux et éventuellement des couches intermédiaires.

Bien d'autres variantes sont possibles sans sortir du cadre défini par les revendications annexées.

## Revendications

1. Procédé de traitement d'une structure pour former un espace interne (25) dans ladite structure, consistant à:
réaliser une structure initiale (11) comprenant
- au moins une partie principale (13) et une partie secondaire (21) comprenant des couches superposées qui présentent une interface plate de contact de l'une sur l'autre au moins dans la zone dudit espace interne (25) à former, au moins une desdites couches comprenant un matériau semiconducteur,
- au moins une partie complémentaire (16, 18) comprenant des plots (16) ou des murs (18) présentant des faces opposées (16a, 16b) en appui respectivement l'une sur l'autre desdites parties principale et secondaire, sensiblement parallèlement à ladite interface,
au moins l'une desdites parties (13, 21) présente au moins une région à traiter (20) s'étendant dans le voisinage de ladite partie complémentaire (16, 18) et susceptible de réduire en épaisseur sensiblement perpendiculairement à cette interface sous l'effet d'un traitement thermique;
et à appliquer ce traitement à ladite région à traiter de ladite structure initiale de façon à réaliser une structure finale (12) telle que la réduction d'épaisseur de ladite région relativement au reste de la structure engendre la formation d'un espace interne (25) s'étendant entre lesdites parties principale (13) et secondaire (21), sur au moins une zone de ladite interface et sensiblement parallèlement à cette interface ou à l'intérieur d'au moins l'une desdites parties (13, 21), à distance de et sensiblement parallèlement à ladite interface.

2. Procédé selon la revendication 1, **caractérisé par le fait que** ladite région. à traiter (20) résulte d'une implantation ionique d'amorphisation dans au moins l'une desdites parties, produisant un gonflement du matériau la constituant, et que ledit traitement consiste à recristalliser, préférentiellement par reépitaxie, au moins une partie de la région amorphisée afin de produire une réduction de son épaisseur.

3. Procédé selon l'une quelconque des revendications 1 ou 2, **caractérisé par le fait qu'**une desdites faces de ladite partie complémentaire (16,18) est située dans le plan de ladite interface.

4. Procédé de traitement d'une structure pour former un espace interne (109 ; 209) dans ladite structure, consistant à:
réaliser une structure initiale (101 ; 201) comprenant
- au moins une partie principale (103 ; 203) et une partie secondaire (107; 207) comprenant des couches superposées qui présentent une interface (108 ; 208) plate de contact de l'une sur l'autre au moins dans la zone dudit espace interne à former, au moins une desdites couches comprenant un matériau semiconducteur, et
- au moins une partie complémentaire comprenant des plots ou des murs (106 ; 206) présentant des faces opposées (106a, 106b) en appui respectivement sur lesdites parties principale et secondaire,
sensiblement parallèlement à ladite interface, lesdits plots ou murs (106 ; 206) comprenant au moins une région à traiter susceptible d'augmenter en épaisseur sensiblement perpendiculairement à ladite interface sous l'effet d'un traitement thermique;
et à appliquer ce traitement à ladite région à traiter (106 ; 206) de ladite structure initiale de façon à réaliser une structure finale (102 ; 202) telle que l'augmentation d'épaisseur de ladite région de ladite partie complémentaire relativement au reste de la structure produit un déplacement desdites parties principale et secondaire l'une par rapport à l'autre au moins dans le voisinage de ladite partie complémentaire et engendre la formation d'un espace interne (109 ; 209) s'étendant entre lesdites parties principale et secondaire sur au moins une zone de ladite interface et sensiblement parallèlement à cette interface, ou à l'intérieur d'au moins l'une desdites parties, à distance de et sensiblement parallèlement à ladite interface.

5. Procédé selon la revendication 4, **caractérisé par le fait qu'**une desdites faces de ladite partie complémentaire (106 ; 206) est située dans le plan de ladite interface.

6. Procédé selon l'une quelconque des revendications 4 ou 5, **caractérisé par le fait que** ledit traitement thermique consiste à produire des bulles gazeuses dans ladite région à traiter (106 ; 206) de façon à produire ladite augmentation d'épaisseur de ladite partie complémentaire.

7. Procédé selon l'une quelconque des revendications 4 ou 5, **caractérisé par le fait qu'**au moins d'une desdites parties comprend une zone fragilisée (203a) dans laquelle se forme ledit espace interne (209).

8. Procédé selon la revendication 7, **caractérisé par le fait que** ladite zone fragilisée est obtenue par une implantation ionique.

9. Procédé selon l'une des revendications 7 ou 8, **caractérisé par le fait que** l'adhérence desdites couches l'une sur l'autre est supérieure à la résistance de ladite zone fragilisée.

## Patentansprüche

1. Behandlungsverfahren einer Struktur zur Bildung eines Innenraums (25) in der genannten Struktur, bestehend aus:
Realisieren einer anfänglichen Struktur (11), umfassend,
- wenigstens einen Hauptteil (13) und einen sekundären Teil (21), umfassend überlagerte Schichten, die eine flache Kontaktschnittstelle einer auf der anderen wenigstens in dem Bereich des genannten zu bildenden Innenraums (25) aufweisen, wobei wenigstens eine der genannten Schichten ein Halbleitermaterial umfasst,
- wobei wenigstens ein komplementärer Teil (16, 18) Klötze (16) oder Wände (19) umfasst, die entgegengesetzte Seiten (16a, 16b) aufweisen, die jeweils aufeinander auf dem genannten Haupt- und sekundären Teil deutlich parallel zu der genannten Schnittstelle aufliegen,
wenigstens einer der genannten Teile (13, 21) weist wenigstens eine zu behandelnde Region (20) auf, der sich in der Nachbarschaft des genannten komplementären Teils (16, 18) erstreckt und geeignet ist, unter der Wirkung einer thermischen Behandlung deutlich lotrecht zu dieser Schnittstelle in der Dicke abzunehmen;
und in der Anwendung dieser Behandlung auf die genannte zu behandelnde Region der genannten anfänglichen Struktur derart, dass eine endgültige Struktur (12) derart realisiert ist, dass die Dickenabnahme der genannten Region relativ zu dem Rest der Struktur die Bildung eines internen Bereichs (25) nach sich zieht, der sich zwischen den genannten Hauptteilen (13) und dem sekundären Teil (21) über wenigstens einen Bereich der genannten Schnittstelle und deutlich parallel zu dieser Schnittstelle oder im Innern von wenigstens einem der genannten Teile (13, 21) entfernt von und deutlich parallel zu der genannten Schnittstelle erstreckt.

2. Verfahren gemäß Anspruch 1, **dadurch gekennzeichnet, dass** die genannte zu behandelnde Region (20) aus einer ionischen Einbauamorphisierung in wenigstens einem der genannten Teile resultiert, die ein Anschwellen des sie bildenden Materials hervorruft und dass die genannte Behandlung in der Umkristallisierung, bevorzugt per Re-Epitaxie, wenigstens eines Teils der amorphisierten Region besteht, um eine Abnahme ihrer Dicke hervorzurufen.

3. Verfahren gemäß irgendeinem der Ansprüche 1 oder 2, **gekennzeichnet durch** die Tatsache, dass eine der genannten Seiten des genannten komplementären Teils (16, 18) in der Ebene der genannten Schnittstelle angeordnet ist.

4. Verfahren zur Behandlung einer Struktur zur Bildung eines Innenraums (109; 209) in der genannten Struktur, bestehend aus:
Herstellung einer anfänglichen Struktur (101; 201) umfassend
- wenigstens einen Hauptteil (103; 203) und einen sekundären Teil (107; 207), umfassend überlagerte Schichten, die eine flache Kontaktschnittstelle (108; 208) einer auf der anderen wenigstens in dem Bereich des genannten, zu bildenden Innenraums wenigsten einer der genannten Schichten, die ein Halbleitermaterial umfassen, aufweisen, und
- wenigstens einen komplementären Teil, umfassend Klötze oder Wände (106; 206), die entgegensetzte Seiten (106a, 106b) aufweisen, die sich jeweils auf den genannten Haupt- und sekundären Teilen aufstützen, die deutlich parallel zu der genannten Schnittstelle sind,
wobei die genannten Klötze oder Wände (106; 206) wenigstens eine zu behandelnde Region umfassen, die geeignet ist, unter der Wirkung einer thermischen Behandlung in der Dicke deutlich lotrecht zu der genannten Schnittstelle zuzunehmen;
und in der Anwendung dieser Behandlung auf die genannte zu behandelnde Region (106; 206) der genannten anfänglichen Struktur derart, dass eine endgültige Struktur (102; 202) derart realisiert wird, dass die Dickenerhöhung der genannten Struktur des genannten komplementären Teils relativ zum Rest der Struktur ein Versetzen der genannten Haupt- und sekundären Teile im Verhältnis zueinander wenigstens in der Nachbarschaft des genannten komplementären Teil erzeugt und die Bildung eines Innenraums (109; 209) erzeugt, der sich zwischen den genannten Haupt- und sekundären Teilen über wenigstens einen Bereich der genannten Schnittstelle und deutlich parallel zu dieser Schnittstelle oder im Innern wenigstens einer der genannten Teile entfernt von und deutlich parallel zu der genannten Schnittstelle erstreckt.

5. Verfahren gemäß Anspruch 4, **gekennzeichnet durch** die Tatsache, dass eine der genannten Seiten des genannten komplementären Teils (106; 206) in der Ebene des genannten Teils angeordnet ist.

6. Verfahren gemäß irgendeinem der Ansprüche 4 oder 5, **gekennzeichnet durch** die Tatsache, dass die genannte thermische Behandlung in der Erzeugung von gashaltigen Blasen in der genannten, zu behandelnden Region (106; 206) derart besteht, dass die genannte Dickenerhöhung des genannten komplementären Teils erzeugt wird.

7. Verfahren gemäß irgendeinem der Ansprüche 4 oder 5, **gekennzeichnet, durch** die Tatsache, dass wenigstens eines der genannten Teile einen brüchigen Bereich (203a) umfasst, in dem der genannte Innenraum (206) gebildet wird.

8. Verfahren gemäß Anspruch 7, **gekennzeichnet durch** die Tatsache, dass der genannte brüchige Bereich durch einen ionischen Einbau erhalten wird.

9. Verfahren gemäß einem der Ansprüche 7 oder 8, **gekennzeichnet durch** die Tatsache, dass die Adhärenz der genannten Schichten aufeinander größer ist als der Widerstand des genannten brüchigen Bereichs.

## Claims

1. A method for treating a structure to form an inner space (25) in said structure, consisting in:
making an initial structure (11) comprising
- at least one main part (13) and one secondary part (21) comprising superimposed layers which have a flat interface contacting each other at least in the area of said inner space (25) to be formed, at least one of said layers comprising a semi-conducting material,
- at least one complementary part (16, 18) comprising studs (16) or walls (18) having opposite faces (16a, 16b) respectively bearing against each other of said main and secondary parts, substantially parallel to said interface,
at least one of said parts (13, 21) has at least one region to be treated (20) extending in the vicinity of said complementary part (16, 18) and likely to decrease in thickness substantially perpendicular to this interface under the effect of a heat treatment;
and in applying this treatment to said region to be treated of said initial structure so as to make a final structure (12) such that the decrease in thickness of said region relative to the remainder of the structure results in forming an inner space (25) extending between said main (13) and secondary (21) parts, over at least one area of said interface and substantially parallel to this interface or inside at least one of said parts (13, 21), at a distance from and substantially parallel to said interface.

2. The method according to claim 1, **characterised in that** said region to be treated (20) results from an amorphisation ion implantation in at least one of said parts, generating a swelling of the material composing it, and that said treatment consists in recrystallising, preferably by re-epitaxy, at least one part of the amorphised region in order to produce a decrease of its thickness.

3. The method according to any of claims 1 and 2, **characterised in that** one of said faces of said complementary part (16, 18) is located in the plane of said interface.

4. A method for treating a structure to form an inner space (109; 209) in said structure, consisting in:
making an initial structure (101; 201) comprising
- at least one main part (103; 203) and one secondary part (107; 207) comprising superimposed layers which have a flat interface (108; 208) contacting each other at least in the area of said inner space to be formed, at least one of said layers comprising a semi-conducting material, and
- at least one complementary part comprising studs or walls (106; 206) having opposite faces (106a, 106b) respectively bearing against said main and secondary parts, substantially parallel to said interface,
said studs or walls (106; 206) comprising at least one region to be treated likely to increase in thickness substantially perpendicular to said interface under the effect of a heat treatment;
and in applying this treatment to said region to be treated (106; 206) of said initial structure so as to make a final structure (102; 202) such that the increase in thickness of said region of said complementary part relative to the remainder of the structure causes said main and secondary parts to be displaced from each other at least in the vicinity of said complementary part and results in forming an inner space (109; 209) extending between said main and secondary parts over at least one area of said interface and substantially parallel to this interface, or inside at least one of said parts, at a distance from and substantially parallel to said interface.

5. The method according to claim 4, **characterised in that** one of said faces of said complementary part (106; 206) is located in the plane of said interface.

6. The method according to any of claims 4 and 5, **characterised in that** said heat treatment consists in generating gas bubbles in said region to be treated (106; 206) so as to generate said increase in thickness of said complementary part.

7. The method according to any of claims 4 and 5, **characterised in that** at least one of said parts comprises an embrittled area (203a) in which said inner space (209) is formed.

8. The method according to claim 7, **characterised in that** said embrittled area is obtained by ion implantation.

9. The method according to one of claims 7 and 8, **characterised in that** the adhesion of said layers to each other is greater than the strength of said embrittled area.
